# EUROPÄISCHE PATENTSCHRIFT

(11) **EP 3 791 007 B1**
(45) Veröffentlichungstag und Bekanntmachung des Hinweises auf die Patenterteilung: **12.01.2022**
(21) Anmeldenummer: 19726322.1
(22) Anmeldetag: 13.05.2019
(51) Int. Cl.: C23C 24/04, B05D 1/18, B05C 3/08, B05D 3/12, B05C 3/09

(54) **VERFAHREN ZUR BESCHICHTUNG VON TEILEN IN EINEM TAUCH-SCHLEUDERVERFAHREN**
METHOD FOR COATING PARTS IN A DIP CENTRIFUGATION PROCESS
PROCÉDÉ POUR REVÊTIR DES PIÈCES SELON UN PROCÉDÉ D'ENDUCTION CENTRIFUGE PAR IMMERSION

(30) Priorität: 11.05.2018 DE 102018111331
(43) Veröffentlichungstag der Anmeldung: 17.03.2021
(73) Patentinhaber: EJOT GmbH & Co. KG, 57319 Bad Berleburg (DE)
(72) Erfinder: SIMONSEN, Fabian, 99084 Erfurt (DE)
(74) Vertreter: Neumann Müller Oberwalleney & Partner Patentanwälte
(86) Internationale Anmeldenummer: PCT/EP2019/062191
(87) Internationale Veröffentlichungsnummer: WO 2019/215343

(56) Entgegenhaltungen:
- EP-A1- 0 336 983
- DE-U1- 29 911 753
- TW-U- M 463 614

## Beschreibung

Die Erfindung betrifft ein Verfahren zur Beschichtung von Teilen in einem Tauch-Schleuderverfahren gemäß dem Oberbegriff des Anspruchs 1.

Zur Beschichtung von Schrauben oder anderem Schüttgut ist ein Tauch-Schleuder-Verfahren bekannt.

Dabei wird das Schüttgut in eine Korbanordnung gefüllt, der in ein Beschichtungsmittel getaucht wird, wobei die Korbanordnung anschließend in einer Planeten-Zentrifuge zentrifugiert wird, wobei eine Korbanordnung, die aus einem Korb besteht, um eine konzentrisch zur Korbanordnung liegende Planetendrehachse gedreht wird. Es kann so auch eine Mehrzahl von Körbe um ihre Planetendrehachsen gedreht werden.- Die Korbdrehachse ist exzentrisch am Rotor einer Zentrifuge angeordnet und liegen gleichverteilt auf einem Kreisumfang um die Hauptrotorachse. Eine solche Anordnung ist beispielsweise aus der DE 299 11 753 U1 bekannt.

Für einen betriebswirtschaftlich sinnvollen Durchsatz muss eine größere Menge Schüttgut in die Korbanordnung gefüllt werden.

Dadurch ergibt sich das Problem, dass bei den notwendigen Drehzahlen zur effektiven Abschleuderung der Beschichtungsflüssigkeit das Schüttgut sich aufgrund der Zentrifugalkräfte in einem Bereich der Planetenkorbanordnung anlagert und dort aufgrund der hohen Reibung keine nennenswerte Relativbewegung mehr zwischen den Teilen zulässt.

Durch die so an der Planetenkorbanordnung angelagerten Teile, wird ein hohes Gegendrehmoment erzeugt, so dass eine freie Drehung des Planetenkorbs entgegen der Hauptdrehachse verhindert wird.

Dies führt dazu, dass eine notwendige Durchmischung und Lageänderung der einzelnen Elemente des Schüttguts nicht erfolgt und so das Beschichtungsmittel aus den kleinen schöpfenden Strukturen nicht zuverlässig abgeschleudert werden kann.

Es ist Aufgabe der Erfindung ein Verfahren zum Beschichten von Bauteilen, die kleine schöpfende Strukturen aufweisen, anzugeben.

Bei Schrauben sind dies regelmäßig die Innenantriebe von kleinen Schrauben, aus welchen das Beschichtungsmittel nicht vollständig ausgeschleudert werden kann.

In bekannter Weise umfasst ein Beschichtungsverfahren eine Planetenkorbanordnung, die mit Schüttgut befüllt wird und die in ein Beschichtungsmittel getaucht wird. Um die notwendige Durchmischung zu gewährleisten kann die Planetenkorbanordnung nur teilweise mit Schüttgut befüllt werden, wobei das übrige Aufnahmevolumen frei bleibt. Das in der Planetenkorbanordnung befindliche Schüttgut wird anschließend an einer Planeten-Zentrifuge, die einen um eine Hauptrotordrehachse drehenden Hauptrotor aufweist einem Schleudervorgang unterzogen. Der Schleudervorgang findet derart statt, dass sich während der Drehung des Hauptrotors die wenigstens eine Planetenkorbanordnung um ihre Planetendrehachse dreht, wobei die Planetendrehachse exzentrisch, also radial zur Hauptrotordrehachse beabstandet, am Hauptrotor angeordnet ist.

Erfindungsgemäß ist dazu vorgesehen, dass eine Planeten-Zentrifuge verwendet wird, die eine Planetenkorbanordnung aufweist, die eine Mehrzahl von Planetenkörben umfasst, die insbesondere symmetrisch, um die Planetendrehachse der Planetenkorbanordnung drehbar angeordnet sind.

Bevorzugt ist eine ungerade Anzahl von Planetenkörben vorgesehen.

Durch die ungerade Anzahl von Planetenkörben werden je Planetenkorb unterschiedliche Drehmomente um die Planetendrehachse erzeugt, so dass diese während der Drehung in unterschiedlichen Drehrichtungen wirken.

Dadurch wird das um die Planetendrehachse entgegen der Drehrichtung wirkende Drehmoment - Rückstellmoment - reduziert und eine Drehung der Planetenkorbanordnung um einen großen Drehwinkel ermöglicht, der nicht durch das Rückstellmoment beschränkt wird.

Dadurch kann die Drehung der Planetenkörbe um die Planetendrehachse während des Zentrifugierens einen großen Drehwinkel, von insbesondere mehr als 360°, erreichen. So erfahren die einzelnen Elemente eine kontinuierliche Lageänderung, wodurch eine zuverlässige Abschleuderung des in den kleinen schöpfenden Strukturen aufgenommenen Beschichtungsmittels gewährleistet ist.

Die Drehrichtung um die wenigstens eine Planetendrehachse, ist insbesondere zu der Drehrichtung der Hauptrotordrehachse entgegengesetzt.

Die Anzahl der Planetenkörbe ist bevorzugt ungerade. Bevorzugt sind drei Planetenkörbe vorgesehen. Weiter bevorzugt weisen die Planetenkörbe einen kreisförmigen Querschnitt auf und liegen mit ihren Wandungen aneinander, wobei die Planetendrehachse im Mittelpunkt der Fläche liegt, die sich durch die Verbindung der benachbarten Mittelpunkte der Planetenkörbe ergibt.

Die Planetenkörbe werden insbesondere mit einer gleichen Masse an Schüttgut befüllt, so dass eine kontinuierliche Verminderung des entgegen der Drehrichtung der Planetendrehachse wirkenden Gegendrehmoments hergestellt wird.

Das Beschichtungsmittel ist bevorzugt ein flüssiger Zinklamellenüberzug, kann aber auch beispielsweise ein Aluminiumlamellenüberzug sein.

Die verwendete Zentrifuge kann mehrere Planetendrehachsen aufweisen, um die jeweils eine erfindungsgemäße Planetenkorbanordnung drehbar gelagert ist. Die Planetenkorbanordnung weist einen Radius eines die Planetenkörbe umhüllenden Kreises auf, dessen Radius geringer ist als der Abstand der Planetendrehachse von der Hauptrotorachse. Bevorzugt entspricht der Abstand in etwa diesem Radius.

Die Drehzahl für den Hauptrotor beträgt bevorzugt zwischen 120 U/min und 450 U/min. Die Drehzahl für die Planetenkorbanordnung beträgt bevorzugt zwischen 0,5 U/min und 5 U/min.

Dadurch kann eine Durchmischung, insbesondere eine Lageänderung der kleinen Elemente während des Zentrifugierens gewährleistet werden.

Der Abstand der Planetendrehachse von der Hauptrotorachse beträgt bevorzugt zwischen 0,2 m und 1m.

Weitere Vorteile, Merkmale und Anwendungsmöglichkeiten der vorliegenden Erfindung ergeben sich aus der nachfolgenden Beschreibung in Verbindung mit den in den Zeichnungen dargestellten Ausführungsbeispielen.

In der Zeichnung bedeutet:
- Fig. 1: eine exemplarische Darstellung einer Vorrichtung die zum Abschleudern überschüssiger Beschichtungsflüssigkeit in einem erfindungsgemäßen Beschichtungsverfahren eingesetzt wird, und
- Fig. 2: eine exemplarische Darstellung einer Vorrichtung die zum Abschleudern überschüssiger Beschichtungsflüssigkeit mit zwei Planetenkorbanordnungen in einem erfindungsgemäßen Beschichtungsverfahren eingesetzt wird.

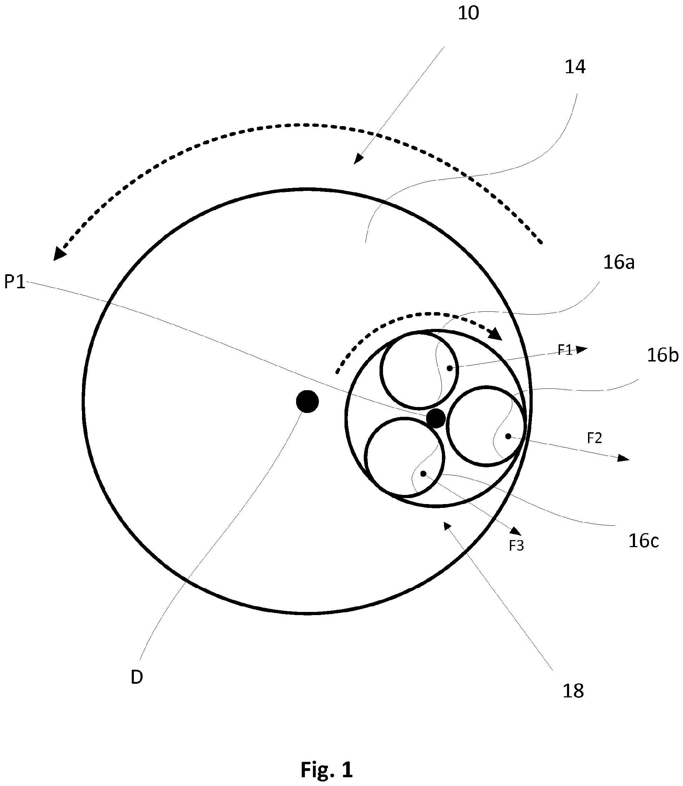

Fig. 1 zeigt eine Planetenzentrifuge 10 mit einer Hauptdrehachse D, um die sich der Hauptrotor 14 in einer ersten Drehrichtung drehen kann. Exzentrisch am Hauptrotor 14 ist eine Planetenkorbanordnung 18 vorgesehen, die sich um ihre Planetendrehachse P1 dreht. Erfindungsgemäß umfasst die Planetenkorbanordnung 18 in der vorliegenden Ausführung drei Planetenkörbe 16a, 16b, 16c, wobei alle drei Planetenkörbe 16a,16b, 16c mit der gleichen oder der annähernd gleichen Menge an beschichteten Teilen befüllt sind.

Die Drehrichtung des Hauptrotors 14 läuft im vorliegenden Ausführungsbeispiel entgegen dem Uhrzeigersinn, wohingegen die Drehrichtung der Planetenkorbanordnung 18 im Uhrzeigersinn orientiert ist.

Die Drehzahl des Hauptrotors liegt im vorliegenden Fall bei 300 U/min und die Drehzahl der Planetenkorbanordnung 18 bei etwa 1 U/min.

Dadurch ergeben sich in einer Momentaufnahme während der Zentrifugation die Kräfte F1, F2, F3 aufgrund der in der in den Planetenkörben 16a, 16b, 16c verteilten Teile. Die Kräfte F2, F3 erzeugen ein Moment entgegen der Drehrichtung, wohingegen F1 ein Moment in Drehrichtung erzeugt. Dies reduziert erheblich die Belastung des Antriebsmotors für die Drehung der Planetenkorbanordnung 18, so dass überhaupt eine Drehung der Planetenkorbanordnung 18 über 360° möglich ist und ausgeführt wird, was zu einer Durchmischung und Lageänderung der zu beschichtenden Teile führt. Die Planetenkörbe 16a, 16b, 16 c sind in ihrer Wandung so beschaffen, dass die Beschichtungsflüssigkeit während der Zentrifugation abgeführt werden kann. Insbesondere sind sie als Gitterkörbe ausgeführt. Durch das erfindungsgemäße Verfahren kann die Beschichtungsflüssigkeit zuverlässig aus kleinsten schöpfenden Strukturen abgeschleudert werden. Dies hat insbesondere bei kleinen Schraubenantrieben den Vorteil, dass überschüssige Beschichtung im Antrieb der idealen Aufnahme des Antriebs-Bits nicht entgegenwirkt.

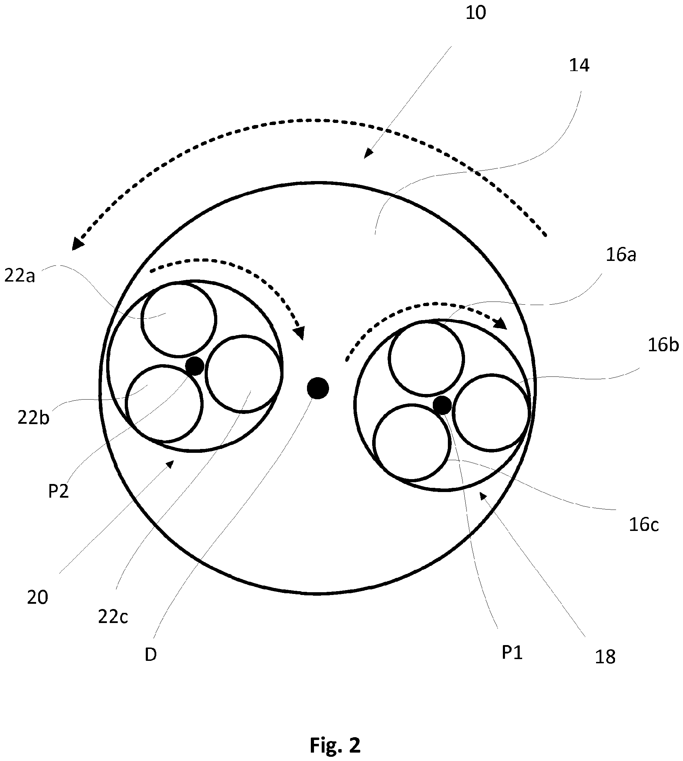

Fig. 2 zeigt eine weitere schematische Ansicht einer Planetenzentrifuge, wie sie im erfindungsgemäßen Beschichtungsverfahren eingesetzt wird. Sie weist zusätzlich zu der in Fig.1 beschriebenen Anordnung eine zweite Planetenkorbanordnung 20 mit drei Planetenkörben 22a, 22b, 22c auf, die um ihre Planetendrehachse P2 gedreht werden.

Dadurch kann der Durchsatz der in einem Beschichtungsvorgang zu bearbeitenden Teile erhöht werden.

## Patentansprüche

1. Beschichtungsverfahren zur Beschichtung von Teilen in einem Tauch-Schleuder-Verfahren, wobei die zu beschichtenden Teile in eine Beschichtungsflüssigkeit getaucht werden, wobei die zu beschichtenden Teile anschließend in einer Planetenkorbanordnung (18, 20) in einer Planetenzentrifuge (10) geschleudert werden, wobei die Planetenzentrifuge (10) einen um eine Hauptrotordrehachse (D) drehenden Hauptrotor (14) aufweist, wobei sich die wenigstens eine Planetenkorbanordnung (18, 20) um ihre Planetendrehachse (P1, P2) dreht, und ferner die Planetendrehachse (P1, P2) exzentrisch am Hauptrotor (14) angeordnet ist, **dadurch gekennzeichnet, dass** eine Planetenzentrifuge (10) verwendet wird, die eine Planetenkorbanordnung (18, 20) aufweist, die eine Mehrzahl von Planetenkörben (16a, 16b, 16c; 22a, 22b, 22c) umfasst, die um die Planetendrehachse (P1, P2) der Planetenkorbanordnung (18, 20) drehbar angeordnet sind, wobei die Planetenkorbanordnung (18, 20) während des Schleudervorgangs gedreht wird.

2. Beschichtungsverfahren nach Anspruch 1, **dadurch gekennzeichnet, dass** eine Planetenkorbanordnung (18, 20) mit einer ungeraden Anzahl an Planetenkörben (16a, 16b, 16c; 22a, 22b, 22c) verwendet wird.

3. Beschichtungsverfahren nach einem der vorangehenden Ansprüche, **dadurch gekennzeichnet, dass** mehrere Planetenkorbanordnungen (18, 20) verwendet werden.

4. Beschichtungsverfahren nach einem der vorangehenden Ansprüche, **dadurch gekennzeichnet, dass** die zu beschichtenden Teile in den Planetenkörben (16a, 16b, 16c; 22a, 22b, 22c) in die Beschichtungsflüssigkeit getaucht werden.

5. Beschichtungsverfahren nach einem der vorangehenden Ansprüche, **dadurch gekennzeichnet, dass** die Drehzahl um die Hauptdrehachse (D) zwischen 120 U/min und 450 U/min beträgt.

6. Beschichtungsverfahren nach einem der vorangehenden Ansprüche, **dadurch gekennzeichnet, dass** die Drehzahl um die Planetendrehachse (P1, P2) zwischen 0,5 U/min und 5 U/min beträgt.

7. Beschichtungsverfahren nach einem der vorangehenden Ansprüche, **dadurch gekennzeichnet, dass** die Planetenkorbanordnung (18, 20) während des Schleudervorgangs um mehr als 360° um ihre Planetendrehachse (P1, P2) gedreht wird.

## Claims

1. Coating method for coating parts in a dip-spin process, wherein the parts to be coated are dipped into a coating liquid, wherein the parts to be coated are subsequently centrifuged in a planetary basket arrangement (18, 20) in a planetary centrifuge (10), wherein the planetary centrifuge (10) comprises a main rotor (14) rotating about a main rotor axis of rotation (D), wherein the at least one planetary basket arrangement (18, 20) rotates about its planetary axis of rotation (P1, P2), and further wherein the planetary axis of rotation (P1, P2) is arranged eccentrically on the main rotor (14),
**characterised in**
**that** a planetary centrifuge (10) is used which has a planetary basket arrangement (18, 20) comprising a plurality of planetary baskets (16a, 16b, 16c; 22a, 22b, 22c) which are arranged rotatably about the planetary axis of rotation (P1, P2) of the planetary basket arrangement (18, 20), wherein the planetary basket arrangement (18, 20) is rotated during the centrifuging operation.

2. Coating method according to claim 1, **characterised in**
**that** a planetary basket arrangement (18, 20) is used with an odd number of planetary baskets (16a, 16b, 16c; 22a, 22b, 22c).

3. Coating method according to any one of the preceding claims, **characterised in that** several planetary basket arrangements (18, 20) are used.

4. Coating method according to any one of the preceding claims, **characterised in that** the parts to be coated in the planetary baskets (16a, 16b, 16c; 22a, 22b, 22c) are dipped into the coating liquid.

5. Coating method according to any one of the preceding claims, **characterised in that** the speed around the main axis of rotation (D) is between 120 rpm and 450 rpm.

6. Coating method according to any one of the preceding claims, **characterised in that** the speed around the planetary rotation axis (P1, P2) is between 0.5 rpm and 5 rpm.

7. Coating method according to any one of the preceding claims, **characterised in that** the planetary basket arrangement (18, 20) is rotated by more than 360° about its planetary rotation axis (P1, P2) during the centrifuging process.

## Revendications

1. Procédé d'enduction, destiné à enduire des pièces selon un procédé d'enduction centrifuge par immersion, les pièces qui doivent être enduites étant immergées dans un liquide d'enduction, les pièces qui doivent être enduites étant ensuite centrifugées dans un ensemble de récipients planétaires (18, 20) dans une centrifugeuse planétaire (10), la centrifugeuse planétaire (10) comportant un rotor principal (14), tournant autour d'un axe de rotation (D) de rotor principal, l'au moins un ensemble de récipients planétaires (18, 20) tournant autour de son axe de rotation (P1, P2) planétaire, et par ailleurs l'axe de rotation (P1, P2) planétaire étant placé de manière excentrique sur le rotor principal (14), **caractérisé en ce qu'**il est utilisé une centrifugeuse planétaire (10), qui comporte un ensemble de récipients planétaires (18, 20), qui comprend une multiplicité de récipients planétaires (16a, 16b, 16c ; 22a, 22b, 22c), qui sont placés en étant rotatifs autour de l'axe de rotation (P1, P2) planétaire de l'ensemble de récipients planétaires (18, 20), l'ensemble de récipients planétaires (18, 20) étant tourné pendant le processus de centrifugation.

2. Procédé d'enduction selon la revendication 1, **caractérisé en ce que** l'on utilise un ensemble de récipients planétaires (18, 20) pourvu d'un nombre impair de récipients planétaires (16a, 16b, 16c ; 22a, 22b, 22c).

3. Procédé d'enduction selon l'une quelconque des revendications précédentes, **caractérisé en ce que** l'on utilise plusieurs ensembles de récipients planétaires (18, 20).

4. Procédé d'enduction selon l'une quelconque des revendications précédentes, **caractérisé en ce que** l'on immerge les pièces qui doivent être enduites dans les récipients planétaires (16a, 16b, 16c ; 22a, 22b, 22c) dans le liquide d'enduction.

5. Procédé d'enduction selon l'une quelconque des revendications précédentes, **caractérisé en ce que** la vitesse de rotation autour de l'axe de rotation principal (D) se situe entre 120 t/minute et 450 t/minute.

6. Procédé d'enduction selon l'une quelconque des revendications précédentes, **caractérisé en ce que** la vitesse de rotation autour de l'axe de rotation (P1, P2) planétaire se situe entre 0,5 t/minute et 5 t/minute.

7. Procédé d'enduction selon l'une quelconque des revendications précédentes, **caractérisé en ce que** l'on fait tourner l'ensemble de récipients planétaires (18, 20) pendant le processus de centrifugation de plus de 360° autour de son axe de rotation (P1, P2) planétaire.
